Europäisches Patentamt

European Patent Office

Office européen des brevets

(11) Publication number: **0 272 051 B1**

## EUROPEAN PATENT SPECIFICATION

(45) Date of publication of patent specification: **16.09.92**   (51) Int. Cl.5: **H01L 21/90**, H01L 23/52

(21) Application number: **87310857.5**

(22) Date of filing: **10.12.87**

(54) Reduced area butting contact structure.

(30) Priority: **17.12.86 US 944150**

(43) Date of publication of application:
**22.06.88 Bulletin 88/25**

(45) Publication of the grant of the patent:
**16.09.92 Bulletin 92/38**

(84) Designated Contracting States:
**AT BE CH DE ES FR GB GR IT LI LU NL SE**

(56) References cited:
**US-A- 4 663 831**

**IBM TECHNICAL DISCLOSURE BULLETIN, vol. 22, no. 11, April 1980, pages 5155-5156, New York, US; V.J.SILVESTRI et al.: "Integrated circuit processing concept"**

(73) Proprietor: **ADVANCED MICRO DEVICES, INC. 901 Thompson Place P.O. Box 3453 Sunnyvale, CA 94088(US)**

(72) Inventor: **Sander, Craig S. 182D Ada Avenue Mt. View California 94043(US)** Inventor: **Klein, Richard K. 184A Ada Avenue Mt. View California 94043(US)** Inventor: **Choi, Tat C. 759 Folsom Circle Milpitas California 95035(US)**

(74) Representative: **Sanders, Peter Colin Christopher et al BROOKES & MARTIN High Holborn House 52/54 High Holborn London WC1V 6SE(GB)**

## Description

The present invention relates to an integrated semiconductor circuit according to the first part of claim 1 with butting contact structures, and more particularly, to reducing the area of butting contact structures such as those employed in static random access memory (RAM) cells.

Butting contact structures form an electrical connection between doped regions in a silicon layer and one or more polysilicon layers. They are especially useful in four-transistor static RAM cells where an electrical connection is required between layers of polysilicon and the doped silicon region.

In the conventional four-transistor static RAM cell, a butting contact is made by patterning a gate polysilicon layer (gate poly) with an underlying gate oxide laying over a doped silicon region and covering the entire region, including the gate poly, with an oxide, such as silicon dioxide. A contact hole is then etched in the oxide exposing portions of both the gage poly and the doped silicon region. This particular contact hole, usually referred to as a quasi-buried contact, is distinct from the contact hole used to connect a first metal layer to underlying layers.

A polysilicon layer, called the load poly, is then deposited on top of the exposed portions of both the gate poly and the doped silicon region. This poly layer is then patterned and selectively doped in the vicinity of the contact hole to make electrical contact to and between the gate poly and the doped silicon region.

This contact structure requires a large layout area because the load poly must cover the contact hole entirely even under the worst-case conditions of misalignment and other process variations. If the contact hole is not completely covered by the load poly, then either a portion of the doped silicon region or the gate poly may be etched away when the load poly is defined and etched, which can lead to improper operation of the memory cell.

In the present specification and according to the characterising portion of claim 1, there is described a contact structure in which electrical connection of one or more layers of polysilicon is provided to a doped silicon region. The corresponding process is disclosed in claim 13.

The electrical connection is provided in as small an area as possible.

In particular, there is disclosed a four-transistor static RAM cell with a butting contact permitting reduced layout area that also provides electrical connection of one or more layers of polysilicon to the doped silicon region.

Briefly, a reduced area butting contact structure for an integrated circuit, especially four-transistor static RAM cells, is disclosed.

The dependent claims disclose particular embodiments of the present application.

The contact structure interconnects by means of a conductive plug a doped region of a semiconductor material with at least one polysilicon segment, which may be a first-layer, or gate, polysilicon segment and/or an upper-layer polysilicon segment, including a load polysilicon segment.

The gate polysilicon, if present, is separated from the doped region by a thin oxide layer. Any upper-layer polysilicon segments, if present, are each positioned between and bordered above and below by upper layers of insulating material.

The conductive plug comprises a conductive material confined in and substantially filling a contact hole, which is positioned over a portion of the doped region and a portion of the first-layer polysilicon segment and portions of the upper-layer polysilicon segments.

The contact hole extends from the surface of the uppermost upper layer of insulating material through the portions of the upper-layer polysilicon segments which are contacted and the upper layers of insulating material down to and terminating on the portion of the first-layer polysilicon segment and the portion of the doped region.

The contact hole is formed by using an anisotropic etching process to etch through all upper layers, stopping at the doped region and/or gate poly layer. The contact hole is then filled by a conductive plug comprising a material such as tungsten or polysilicon. Thus, electrical contact with all silicon layers present and the doped silicon region may be made.

In the anisotropic etching process, a two-step etch is employed. The first etch is non-specific as to material, etching all relevant materials (polysilicon and oxide) at substantially the same rate and is continued past any upper polysilicon layers, but is terminated prior to etching any gate polysilicon layers or the doped silicon region.

The second etch is specific as to material, etching silicon dioxide faster than polysilicon or silicon, and thus does not substantially etch the doped silicon region or the gate polysilicon layer.

The contact may be used to connect one, two, or several layers of polysilicon with the doped silicon region. The contact significantly reduces layout area of butting contacts between the doped silicon region and one or more layers of polysilicon. This in turn allows a significant reduction in the size of a four-transistor static RAM cell, which results in a cost advantage due to smaller die size.

Other objects, features and advantages of a contact structure embodying the present invention will become apparent upon consideration of the following detailed description and accompanying drawings, in which like reference designations represent like features throughout the FIGURES.

The drawings referred to in this description should be understood as not being drawn to scale except if specifically noted. Moreover, the drawings are intended to illustrate only one portion of an integrated circuit fabricated in accordance with the present invention.

In the drawings, by way of example only:-

FIG. 1 is a top plan view of a conventional butting contact in a four-transistor static RAM cell;

FIG. 2 is a cross-sectional view taken along the line 2-2 of FIG. 1;

FIG. 3 is a top plan view of a butting contact embodying the invention; and

FIGS. 4a--d depict, in cross-sectional view, taken along the line 4-4 of FIG. 3, the sequence of processing to form the butting contact of FIG. 3.

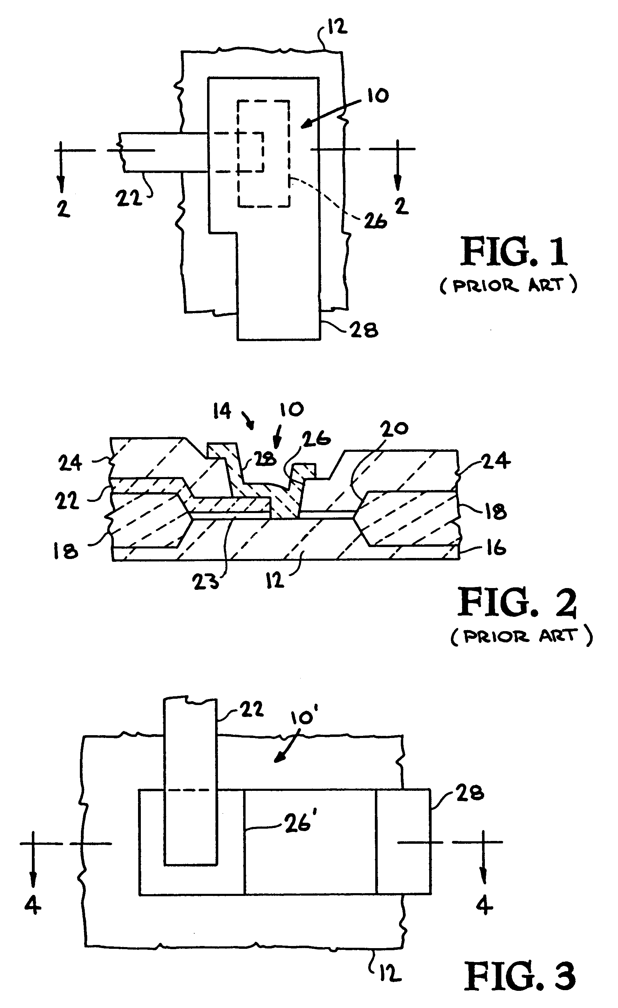

The traditional ways of making a butting contact shown generally at 10, in a four-transistor static RAM cell is depicted in FIGS. 1 and 2. There, a doped region 12 is formed in a portion of a semiconductor substrate 16, surrounded by a field region defined by a field oxide 18. The doped region 12 is typically formed by diffusion, although other techniques, such as ion implantation, may also be employed. Silicon-based technology is commonly employed at the present time to form such memory cells.

A polysilicon layer 22, which is an extension of a connection to a gate (not shown) in another part of the substrate, overlies a thin oxide layer 23. The thin oxide layer 23, which is typically less than about 1,000 Å thick, and usually less than about 500 Å thick, is formed during the formation of the gate oxide employed in the gate (not shown), and accordingly is called the gate oxide, although it serves no such function at the contact area 10. Similarly, the polysilicon layer 22 is referred to as the gate poly.

The gage poly 22 overlying the doped silicon region 12 is patterned and is covered with an oxide 24. A contact hole 26 is then etched in the oxide 24, exposing portions of both the gate poly 22 and the doped silicon region 12.

A polysilicon layer 28, called the load poly, is then deposited on top of both the gate poly 22 and the doped silicon region 12 so as to overlap the contact hole 26 and is patterned. This overlap must be sufficient to ensure complete contact hole 26 coverage even under the worst conditions of misalignment and other process variations. Portions of the polysilicon layer 28 are appropriately doped to provide both a resistive load and an ohmic contact. It will be seen in FIG. 2 that the load poly 28 provides electrical connection between the load poly, the gate poly 22 and the doped region 12.

Reference is now made to the embodiment of Fig. 3. Alternative embodiments are also briefly described as applicable. Although the discussion is presented specifically with regard to silicon-based technology, it will be appreciated that other semiconductor materials and the corresponding insulating materials may be employed.

The novel structure of Fig. 3 utilizes a conductive plug which is self-aligned to the contact hole to form an electrical connection between a doped silicon region and one or more layers of polysilicon. This structure does not require a separate contact hole which is distinct from the contact hole used for electrical connection between the first metal and underlying conductive layers. Using this approach, contact to the load poly is made at an edge of the load poly and area is saved because it is not necessary to have the load poly overlap the edge of the contact hole.

In the process for producing the contact structure, a preferred contact etch is utilised in order to fabricate the reduced area contact 10' of Fig. 3.

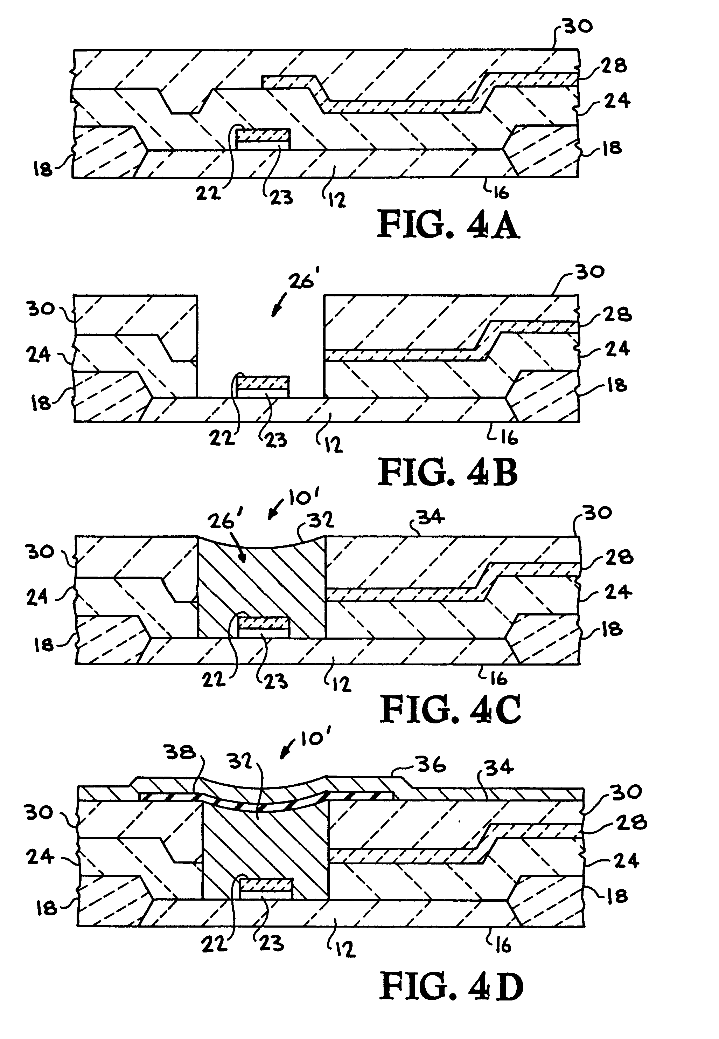

As seen therein, the load poly 28 is not required to overlap the contact hole 26'. In fact, the only requirement is that the contact 10' touches the load poly 28 under worst-case conditions of misalignment. The contact 10' is made in the following manner, referring now to FIGS. 4a-d.

After the polysilicon layers 22, 28 have been deposited and defined over the doped silicon region 12, an oxide 30, such as silicon dioxide, is formed over the entire surface and fully planarized, as seen in FIG. 4a. The planarization process is well-known and does not form a part of this invention.

A contact hole 26' is defined and etched so as to overlap portions of the load poly 28, the gate poly 22 and the doped silicon region 12. Where both a gate poly 22 and at least one load poly 28 are present, this contact etch is performed using a two-step process.

The first step etches polysilicon and oxide at approximately the same rate. This step is carried out until the etch has gone through the load poly 28, and then the etch is switched to a conventional oxide etch which has a high selectivity to silicon and polysilicon. Consequently, the selective etch etches through the oxide layer 24, but stops at the doped silicon region 12 and gate poly 22. Where the gate poly 22 is absent, the selective etch stops at the doped silicon region 12. The resulting structure is shown in FIG. 4b.

An important condition is that the etch must be anisotropic so that the contact walls 26' are near-vertical. Some slope of the walls, causing the dimension of the top of the contact to be larger than the bottom, is acceptable. In typical applications, the dimension of the top of the contact should not exceed the dimension of the bottom by more than approximately 30%.

It is also important to ensure that the load poly 28 is not substantially recessed relative to the oxide portion of the contact walls. Typically, the undercut of the load poly 28 should be limited such that the edge of the load poly is recessed from the oxide contact wall by no more than approximately 50% of the thickness of the load poly layer.

A variety of etch processes for creating the structure described above are well-known to those skilled in the art. One suitable example employs reactive ion etching (RIE), using $CHF_3$ and $O_2$ chemistry. By varying the relative amounts of $CHF_3$ and $O_2$, it is possible to obtain oxide-to-silicon etch ratios ranging between 0.5 and 20. The relative amounts of these gases should be adjusted for the first step of the etch to produce an etch ratio as close to 1.0 as possible, with values between about 0.75 and 1.5 being generally acceptable. The second step of the etch should be carried out with an etch gas ratio that causes oxide to be etched at a much greater rate than silicon or polysilicon. With this ratio, the etch can be terminated on, without substantially etching, polysilicon or doped silicon regions. An oxide-to-silicon etch ratio greater than about 10 is generally acceptable for the second step of the etch.

The conversion from the first to the second step of the etch should not be carried out until it is certain that etching through the load poly layer 28 or the lowest of additional polysilicon layers other than the gate poly has been completed. This conversion point may be determined by at least two methods. The first method involves timing the etch with knowledge of the relevant etch rates and material thicknesses. Another method utilizes optical or electronic detection of residual etch gases to signal that the polysilicon layer 28 has been completely etched. Of course, if there is more than one polysilicon layer (not including the gate poly layer 22) to be etched through, appropriate adjustments must be made in the above methods.

In some applications, there may be no load poly layer 28 present. In such a case, then only the second etch step, which terminates at the surface of the gate poly 22 and the surface of the doped silicon region 12, is employed.

The thickness of the oxide 24 between the load poly 28 and the gate poly 22 must be thick enough to compensate for non-uniformities in both the oxide deposition itself and the first part of the etch cycle. The oxide layer 24 should be thick enough to ensure that on the fastest-etching wafers, the first part of the contact etch does not reach the gate poly 22 or the doped silicon region 12 before the load poly 28 is completely etched through the slowest-etching wafers.

After the contact hole 26′ shown in FIG. 4b has been created by etching, a conductive plus 32 which substantially fills and is confined within the contact hole 26′ is formed. One method to create this plug 32 is to conformally deposit a conductive material to fill the contact hole 26′ and then etch back this material substantially flush to surface 34 of the oxide 30. Examples of such materials include tungsten and doped polysilicon.

Where a doped polysilicon plug 32 is employed and where the underlying doped silicon region 12 and poly gate 22 are doped with an N-type dopant, the plug 32 is then doped $N^+$, such as by a $POCl_3$ pre-deposition and drive. Where the underlying doped silicon region and polysilicon layers are doped with a P-type dopant, the plug 32 is alternatively doped $P^+$, such as by ion implantation of $^{11}B$ or $BF_2$. Finally, in situ-doped polysilicon may also be employed in fabricating the plug 32. The resulting structure is shown in FIG. 4c.

It will be seen that the plug 32 electrically connects the load poly (upper-layer polysilicon segment) 28 and the gate poly (first-layer polysilicon segment) 22 with the doped silicon region 12. Of course, more than one upper-layer polysilicon segment 28 may be present. Also, either the load poly layer 28 or the gate poly 22 may be absent. The reduced area contact 10′ of the invention contemplates all such variations.

It should be noted that no added contact mask is require for the novel butting contact of the invention, as the conventional first contact mask may be employed. The only provision is that all contacts to the load poly 28, even those which do not form butting contacts, require an isolated pad of gate poly 22 or doped silicon region 12 underneath them to act as an etch stop for the contact etch.

Using the structure as described above would require any metal interconnects 36 to be routed around the butting contact 10′, or else the contact would be shorted to the metal. An optional feature which may be used to further increase layout efficiency is an insulating plug cover 38 as shown in FIG. 4d. This cover 38 may be formed by depositing an insulating layer such as $SiO_2$ and then using a non-critical masking step and wet etch to remove this insulator over other contact areas. It is preferable for selectivity purposes that this insulator have a higher etch rate than that of the underlying oxide.

Such a differential etch rate is achieved for two layers of silicon dioxide 30, 38 due to densification of the lower oxide 30 by heat treatment at elevated temperatures greater than about 600°C. The densified oxide 30 etches more slowly than non-densified oxide 38.

Alternatively the upper oxide layer 38 could be doped, say to about 4 to 8%, with phosphorus and with the lower level 30 left undoped. Again, the etch rates of the two oxide layers 30 and 38 would be sufficiently different to permit faster removal of the upper oxide layer 38 compared to other oxide-covered areas.

Finally, silicon nitride could be use in place of silicon dioxide for layer 38.

In any event, the metal interconnect 36 may then be routed directly over the contact 10′ area.

In summary, the novel butting contact 10′ uses the plug 32 to electrically interconnect one or more polysilicon layers (gate poly 22 and/or one or more load poly layers 28) with the doped silicon region 12. The butting contact 10′ also contacts the upper-layer polysilicon segment 28 on the edge by using a special two step anisotropic etch cycle. By these means, the contact area is about one-half the size required for a conventional butting contact. It will thus be appreciated that the contact can be used to connect one, two, or several layers of polysilicon with a doped silicon region.

## Claims

1. An integrated semiconductor circuit structure comprising a doped region (12) of a semiconductor material having a first-layer polysilicon segment (22) and/or at least one upper-layer second polysilicon segment (28), said segment or segments (22, 28) being formed over said doped region (12), connection to said segment or segments (22, 28) being made by means of a butting conductive plug (32), said first-layer polysilicon segment (22) being separated from said doped region (12) by a thin oxide layer (23), either or both segments being covered by an upper layer of insulating material (30), characterised in that said butting conductive plug (32) comprises a conductive material confined in and substantially filling a contact hole (26″), said contact hole extending from the surface of said upper insulating layer (30) down to and terminating on both (a) a portion of said first-layer polysilicon segment (22) and/or said at least one upper-layer second polysilicon segment (28) and (b) a portion of said doped region (12), and said conductive material electrically contacting said first-layer polysilicon segment (22) and/or laterally electrically contacting said at least one upper-layer second polysilicon segment (28).

2. A circuit structure as claimed in Claim 1, characterised in that said first layer polysilicon segment (22) and said oxide layer (23) are present and said thin oxide layer (23) is used as a gate dielectric elsewhere in said integrated circuit.

3. A circuit structure as claimed in Claim 1 or 2, characterised in that at least one upper-layer second polysilicon segment (28) is provided; said at least one upper-layer second polysilicon segment (28) being positioned between and bordered above and below by layers (24,30) of insulating material; said contact hole being positioned over a portion of said doped region (12) and portions of any of said at least one upper-layer polysilicon segment (28) which are contacted; said contact hole extending from the surface of the uppermost said layer of insulating material through portions of said at least one upper-layer second polysilicon segment which are contacted and through said upper layers of insulating material down to and terminating on said portion of said doped region (12).

4. A circuit structure as claimed in Claims 1, 2 or 3, characterised in that said plug (32) comprises a conductive material which can be conformally deposited.

5. A circuit structure as claimed in Claim 4, characterised in that said conductive material comprises tungsten or doped polysilicon.

6. A circuit structure as claimed in any one of Claims 1 to 5, characterised in that said structure comprises a four-transistor static RAM cell.

7. A circuit structure as claimed in any one of Claims 1 to 6, characterised in that said doped region (12) is $N^+$ and said plug (32) is polysilicon doped $N^+$.

8. A circuit structure as claimed in any one of Claims 1 to 6, characterised in that said doped region (12) is $P^+$ and said plug is polysilicon doped $P^+$.

9. A circuit structure as claimed in any one of Claims 1 to 8, characterised in that at least one of said upper-layer polysilicon segments is doped so as to form a high resistance load device.

10. A circuit structure as claimed in any one of Claims 1 to 8, characterised in that at least one of said upper-layer polysilicon segments is doped so as to form a low resistance interconnect.

11. A circuit structure as claimed in any one of Claims 1 to 10, characterised in that there is further provided an insulating plug cover (38) to prevent shorting to an overlying metal interconnect (36).

**12.** A circuit structure as claimed in Claim 11, characterised in that said insulating plug cover (38) comprises silicon dioxide or silicon nitride.

**13.** A process for providing an integrated semiconductor circuit, a portion of said integrated circuit including a doped region (12) of a semiconductor material and at least one upper-layer polysilicon segment (28), and with said at least one upper-layer polysilicon segment positioned between and bordered above and below by upper layers (24, 30) of insulating material, comprising the steps of:

(a) patterning a contact hole geometry and etching through said upper layers (30, 24) of insulating material and through said at least one upper-layer polysilicon segment (28) down to and terminating on said doped region (12) to form said contact hole (26") extending from the surface of the uppermost insulating layer (30) down to said doped region;

(b) forming in said contact hole a plug of conductive material (32) which substantially fills and is contained therein; said plug being in butting contact with said upper-layer polysilicon segment (28), and a portion of said doped region (12).

**14.** A process as claimed in Claim 13, characterised in that said portion of said integrated circuit further includes a first-layer polysilicon segment (22) connected to the gate of a MOS transistor, a portion of which is separated from said doped region by a gate oxide (23), and in that the etching of said contact hole also terminates on a portion of said first-layer polysilicon segment (22).

**15.** A process as claimed in Claim 14, characterised in that said doped region of semiconductor material (12) comprises silicon and said upper layers (30,24) of insulating material comprise silicon dioxide.

**16.** A process as claimed in Claim 15, characterised in that said patterning said contact hole and etching therethrough is done by a two-step etching process which comprises:

(a) a first non-selective etch step comprising an anisotropic etch, non-specific to said upper-layer polysilicon segments and said upper layers of silicon dioxide, for etching through said upper-layer polysilicon segments and said upper layers of silicon dioxide; and

(b) a second selective etch step comprising an anisotropic etch selective to silicon and polysilicon, for etching through any remaining portion of the **lowermost** of said upper layers of silicon dioxide.

**17.** A process as claimed in Claim 16, characterised in that the conversion from said first non-selective etch step to said second selective etch step is performed upon completion of the etch through the lower-most of said upper-layer polysilicon segments and before reaching the doped silicon region or said first-layer polysilicon segment.

**18.** A process as claimed in Claim 16, in which said integrated semiconductor circuit is a four-transistor static RAM memory cell.

**19.** A process as claimed in any one of Claims 13-18, characterised in that said plug consists of tungsten or doped polysilicon which substantially fills and is contained within said contact hole (26'), said doped polysilicon (28) having the same conductivity type as said doped region (12).

**20.** A process as claimed in any one of Claims 16-19, characterised in that the conversion from said first non-selective etch step to said second selective etch step is performed upon completion of the etch through the lower-most of said upper-layer polysilicon segments and before reaching said doped region or said first-layer polysilicon segment.

**21.** A process as claimed in any one of Claims 16-20, characterised in that said first non-selective etch step etches said silicon dioxide at a rate ranging from about 0.75 to 1.5 times that of said polysilicon.

**22.** A process as claimed in any one of Claims 16-21, characterised in that said second selective etch step etches said silicon dioxide at a rate of at least about 10 times that of said silicon and said polysilicon.

**23.** A process as claimed in any of Claims 16-22, characterised in that said etch comprises reactive ion etching, using $CHF_3$ AND $O_2$ chemistry.

**24.** A process as claimed in any one of Claims 13-23, characterised in that said contact hole (26') is formed at the same time that contact holes for interconnecting metal to doped regions or to polysilicon are formed.

25. A process as claimed in any of Claims 13-24, characterised by forming an insulating plug cover between said plug and an overlying metal interconnect.

26. A process as claimed in Claim 25, characterised in that said insulating plug cover comprises silicon dioxide or silicon nitride.

**Patentansprüche**

1. Integrierte Halbleiterschaltungsstruktur mit einem dotierten Bereich (12) eines Halbleitermaterials mit einem ersten Polysiliziumschichtsegment (22) und/oder wenigstens einem oberen zweiten Polysiliziumschichtsegment (28), wobei das Segment oder die Segmente (22, 28) über dem dotierten Bereich (12) ausgebildet sind, wobei die Verbindung mit dem Segment oder den Segmenten (22, 28) leitenden Verbindungsstopfen (32) erfolgt, wobei das erste Polysiliziumschichtsegment (22) von dem dotierten Bereich (12) durch eine dünne Oxidschicht (23) getrennt ist, wobei jeweils eines oder beide Segmente mit einer oberen Schicht aus isolierendem Material (30) bedeckt sind, dadurch gekennzeichnet, daß der leitende Verbindungsstopfen (32) ein leitendes Material aufweist, das in einem Kontacktloch (26') enthalten ist und dieses im wesentlichen ausfüllt, wobei das Kontaktloch sich erstreckt von der Oberfläche der oberen isolierenden Schicht (30) bishinunter zu und endet an sowohl (a) einem Teil des ersten Polysiliziumschichtsegments (22) und/oder des wenigstens einen oberen zweiten Polysiliziumschichtsegments (28) und (b) zu bzw. an einem Teil des dotierten Bereichs (12), und wobei das leitende Material das erste Polysiliziumschichtsegment (22) elektrisch kontaktiert und/oder das wenigstens eine obere zweite Polysiliziumschichtsegment (28) seitlich elektrisch kontaktiert.

2. Schaltungsstruktur nach Anspruch 1, dadurch gekennzeichnet, daß das erste Polysiliziumschichtsegment (22) und die Oxidschicht (23) vorhanden sind und die dünne Oxidschicht (23) an anderer Stelle in der integrierten Schaltung als Gatedielektrikum verwendet wird.

3. Schaltungsstruktur nach Anspruch 1 oder 2, dadurch gekennzeichnet, daß wenigstens ein oberes zweites Polysiliziumschichtsegment (28) vorgesehen ist; wobei das wenigstens eine obere zweite Polysiliziumschichtsegment (28) zwischen Schichten (24, 30) isolierenden Materials angeordnet ist und von diesen oben und begrenzt ist; wobei das Kontaktloch über einem Teil des dotierten Bereichs (12) und kontaktierten Teilen eines beliebigen des wenigstens einen oberen Polysiliziumschichtsegments (28) angeordnet ist; wobei sich das Kontakloch von der Oberfläche der obersten Schicht isolierenden Materials durch die kontaktierten Teile des wenigstens einen oberen zweiten Polysiliziumschichtsegments (28) und durch die oberen Schichten isolierenden Materials hinunter zu dem gennanten Teil des dotierten Bereichs (12) erstreckt und dort endet.

4. Schaltungsstruktur nach den Ansprüchen 1, 2 oder 3, dadurch gekennzeichnet, daß der Stopfen (32) ein leitendes Material aufweist, das konform aufbringbar ist.

5. Schaltungsstruktur nach Anspruch 4, dadurch gekennzeichnet, daß das leitende Material Wolfram oder dotiertes Polysilizium aufweist.

6. Schaltungsstruktur nach einem der Ansprüche 1 bis 5, dadurch gekennzeichnet, daß die Struktur eine statische Viertransistor-RAM-Zelle aufweist.

7. Schaltungsstruktur nach einem der Ansprüche 1 bis 6, dadurch gekennzeichnet, daß der dotierte Bereich (12) $N^+$-dotiert ist und der Stopfen (32) $N^+$-dotiertes Polysilizium ist.

8. Schaltungsstruktur nach einem der Ansprüche 1 bis 6, dadurch gekennzeichnet, daß der dotierte Bereich (12) $P^+$-dotiert ist und der Stopfen $P^+$-dotiertes Polysilizium ist.

9. Schaltungsstruktur nach einem der Ansprüche 1 bis 8, dadurch gekennzeichnet, daß wenigstens eines der oberen Polysiliziumschichtsegmente zur Bildung einer Lastvorrichtung mit hohem Widerstand dotiert ist.

10. Schaltungsstruktur nach einem der Ansprüche 1 bis 8, dadurch gekennzeichnet, daß wenigstens eines der oberen Polysiliziumschichtsegmente zur Bildung einer Zwischenverbindungsschicht mit niedrigem Widerstand dotiert ist.

11. Schaltungsstruktur nach einem der Ansprüche 1 bis 10, dadurch gekennzeichnet, daß ferner eine isolierende Stopfenabdeckung (38) zur Verhinderung eines Kurzschlusses mit einer darüberliegenden Zwischenverbindungsschicht (36) aus Metall vorgesehen ist.

12. Schaltungsstruktur nach Anspruch 11, dadurch gekennzeichnet, daß die isolierende Stopfenabdeckung (38) Siliziumdioxid oder Siliziumnitrid aufweist.

13. Verfahren zum Bilden einer integrierten Halbleiterchaltung, wobei ein Teil der integrierte Schaltung einen dotierten Bereich (12) aus einem Halbleitermaterial und wenigstens ein oberes Polysiliziumschichtsegment (28) aufweist, und wobei das wenigstens eine obere Polysiliziumschichtsegment zwischen oberen Schichten (24, 30) isolierenden Materials angeordnet und von diesen oben und unten begrenzt ist, wobei das Verfahren die folgenden Schritte umfaßt:

(a) Strukturieren einer Kontaktlochgeometrie und Ätzen durch die oberen Schichten (30, 24) isolierenden Materials und durch das wenigstens eine obere Polysiliziumschichtsegment (28) bis hinunter zu und endend an dem dotierten Bereich (12), um das Kontaktloch (26') zu bilden, das sich von der Oberfläche der obersten isolierenden Schicht (30) nach unten zum dotierten Bereich erstreckt;

(b) Bilden eines Stopfens (32) aus leitendem Material in dem Kontakloch, welches dieses im wesentlichen ausfüllt und in diesem enthalten ist; wobei der Stopfen in Verbindungskontakt mit dem oberen Polysiliziumschichtsegment (28) und einem Teil des dotierten Bereichs (12) ist.

14. Verfahren nach Anspruch 13, dadurch gekennzeichnet, daß der Teil der integrierten Schaltung ferner ein erstes, mit dem Gate eines MOS-Transistors verbundenes Polysiliziumschichtsegment (22) aufweist, von dem ein Teil durch ein Gateoxid (23) von dem dotierten Bereich getrennt ist, und daß das Ätzen des Kontaktlochs ebenfalls an einem Bereich des ersten Polysiliziumschichtsegments (22) endet.

15. Verfahren nach Anspruch 14, dadurch gekennzeichnet, daß der dotierte Bereich (12) des Halbleitermaterials Silizium und die oberen Schichten (30, 24) isolierenden Materials Siliziumdioxid aufweisen.

16. Verfahren nach Anspruch 15, dadurch gekennzeichnet, daß das Strukturieren des Kontaktlochs und das Ätzen durch dieses durch einen zweistufigen Ätzvorgang erfolgt, der umfaßt:

(a) einen ersten nicht selektiven Ätzschritt mit einer anisotropen Ätzung, die nicht spezifisch für die oberen Polysiliziumschichtsegmente und die oberen Schichten aus Siliziumdioxid ist, zum Ätzen durch die oberen Polysiliziumschichtsegmente und die oberen Siliziumdioxidschichten, und

(b) einen zweiten selektiven Ätzschritt mit einer anisotropen Ätzung, die selektiv auf Silizium und Polysilizium wirkt, zum Ätzen durch jegliche verbleibenen Teile der untersten der oberen Siliziumdioxidschichten.

17. Verfahren nach Anspruch 16, dadurch gekennzeichnet, daß der Übergang vom ersten, nicht selektiven Ätzschritt zum zweiten, selektiven Ätzschritt bei Beendigung des Ätzens durch das unterste der oberen Polysiliziumschichtsegmente und vor Erreichen des dotierten Siliziumsbereichs des ersten Polysiliziumschichtsegments erfolgt.

18. Verfahren nach Anspruch 16, bei dem die integrierte Halbleiterschaltung eine statische Viertransistor-RAM-Speicherzelle ist.

19. Verfahren nach einem der Ansprüche 13-18, dadurch gekennzeichnet, daß der Stopfen aus Wolfram oder dotiertem Polysilizium besteht, das das Kontaktloch (26') im wesentlichen ausfüllt und in diesem enthalten ist, wobei das dotierte Polysilizium (28) vom gleichen Leitfähigkeitstyp ist wie der dotierte Bereich (12).

20. Verfahren nach einem der Ansprüche 16-19, dadurch gekennzeichnet, daß der Übergang vom ersten, nicht selektiven Ätzschritt zum zweiten, selektiven Ätzschritt bei Beendigung des Ätzens durch das unterste der oberen Polysiliziumschichtsegmente und vor Erreichen des dotierten Bereichs des ersten Polysiliziumschichtsegments erfolgt.

21. Verfahren nach einem der Ansprüche 16-20, dadurch gekennzeichnet, daß der erste, nicht selektive Ätzschritt das Siliziumdioxid mit einer Geschwindigkeit ätzt, die ungefähr 0,75 bis 1,5 mal diejenige für Polysilizium beträgt.

22. Verfahren nach einem der Ansprüche 16-21, dadurch gekennzeichnet, daß der zweite, selektive Ätzschritt das Siliziumdioxid mit einer Geschwindigkeit ätzt, die wenigstens ungefähr das 10-fache derjenigen für Silizium und Polysilizium beträgt.

23. Verfahren nach einem der Ansprüche 16-22, dadurch gekennzeichnet, daß die Ätzung Ätzen mit reaktiven Ionen unter Verwendung der $CHF_3$- und $O_2$-Chemie umfaßt.

24. Verfahren nach einem der Ansprüche 13-23, dadurch gekennzeichnet, daß das Kontakloch (26') gleichzeitig mit der Bildung von Kontaktlöchern zum Verbinden von Metall mit dotierten Bereichen oder mit Polysilizium gebildet wird.

25. Verfahren nach einem der Ansprüche 13-24, gekennzeichnet durch das Bilden einer isolierenden Stopfenabdeckung zwischen dem Stopfen und einer darüberliegenden Zwischenverbindungsschicht aus Metall.

26. Verfahren nach Anspruch 25, dadurch gekennzeichnet, daß die isolierende Stopfenabdeckung Siliziumdioxid oder Siliziumnitrid aufweist.

**Revendications**

1. Une structure de circuit semi-conducteur intégré comprenant une zone dopée (12) d'un matériau semi-conducteur ayant un segment (22) de polysilicium de première couche et/ou au moins un second segment (28) de polysilicium de couche supérieure, le ou lesdits segments (22, 28) étant formés par-dessus ladite zone dopée (12), la connexion avec le ou lesdits segments (22, 28) se faisant au moyen d'un connecteur conducteur bout à bout (32), ledit segment (22) de polysilicium de première couche étant séparé de ladite zone dopée (12) par une mince couche d'oxyde (23), l'un ou l'autre segment ou les deux étant recouverts par une couche supérieure de matériau isolant (30), caractérisée en ce que ledit connecteur conducteur bout à bout (32) est constitué par un matériau conducteur confiné dans et remplissant substantiellement un trou de contact (26'), ledit trou de contact partant de la surface de ladite couche isolante supérieure (30) et descendant pour aboutir sur à la fois (a) une portion dudit segment (22) de polysilicium de première couche et/ou ledit au moins un second segment (28) de polysilicium de couche supérieure et (b) une portion de ladite zone dopée (12), et ledit matériau conducteur contactant électriquement ledit segment (22) de polysilicium de première couche et/ou contactant électriquement latéralement ledit au moins un second segment (28) de polysilicium de couche supérieure.

2. Une structure de circuit selon la Revendication 1, caractérisée en ce que ledit segment (22) de polysilicium de première couche et ladite couche d'oxyde (23) sont présents et en ce que ladite mince couche d'oxyde (23) est utilisée comme diélectrique de grille ailleurs dans ledit circuit intégré.

3. Une structure de circuit selon la Revendication 1 ou 2, caractérisée en ce qu'il est prévu au moins un second segment (28) de polysilicium de couche supérieure; ledit au moins un second segment (28) de polysilicium de couche supérieure étant placé entre et encadré dessus et dessous par des couches (24, 30) de matériau isolant; ledit trou de contact étant placé sur une portion de ladite zone dopée (12) et des portions de tout segment (28) de polysilicium de couche supérieure étant contactées; ledit trou de contact s'étendant de la surface de ladite couche de matériau isolant la plus haute, à travers des portions dudit au moins un second segment de couche supérieure qui sont contactées et à travers lesdites couches supérieures de matériau isolant pour descendre et aboutir sur ladite portion de ladite zone dopée (12).

4. Une structure de circuit selon les Revendications 1, 2 ou 3, caractérisée en ce que ledit connecteur (32) comporte un matériau conducteur qui peut être déposé conformément.

5. Une structure de circuit selon la Revendication 4, caractérisée en ce que ledit matériau conducteur comporte du tungstène ou du polysilicium dopé.

6. Une structure de circuit selon l'une quelconque des Revendications 1 à 5, caractérisée en ce que ladite structure comporte une cellule de RAM statique à quatre transistors.

7. Une structure de circuit selon l'une quelconque des Revendications 1 à 6, caractérisée en ce que ladite zone dopée (12) est N+ et ledit connecteur (32) est du polysilicium dopé N+.

8. Une structure de circuit selon l'une quelconque des Revendications 1 à 6, caractérisée en ce que ladite zone dopée (12) est P+ et ledit connecteur est du polysilicium dopé P+.

9. Une structure de circuit selon l'une quelconque des Revendications 1 à 8, caractérisée en ce qu'au moins un desdits segments de polysilicium de couche supérieure est dopé de manière à former un dispositif de charge à résistance élevée.

10. Une structure de circuit selon l'une quelconque des Revendications 1 à 8, caractérisée en ce qu'au moins un desdits segments de polysilicium de couche supérieure est dopé de manière à former une interconnexion de faible résistance.

11. Une structure de circuit selon l'une quelconque des Revendications 1 à 10, caractérisée en ce qu'il est prévu en outre une couverture isolante du connecteur (38) pour empêcher un court-circuit avec une interconnexion métallique sus-jacente (36).

**12.** Une structure de circuit selon la Revendication 11, caractérisée en ce que ladite couverture isolante du connecteur (38) comporte du dioxyde de silicium ou du nitrure de silicium.

**13.** Un procédé destiné à fournir un circuit semi-conducteur intégré, une portion dudit circuit intégré comprenant une zone dopée 12 d'un matériau semi-conducteur et au moins un segment (28) de polysilicium de couche supérieure, ledit au moins un segment de polysilicium de couche supérieure étant placé entre et encadré dessus et dessous par des couches supérieures (24, 30) de matériau isolant, comportant les étapes consistant à:

(a) configurer une géométrie de trous de contact et à graver à travers lesdites couches supérieures (30,24) de matériau isolant et à travers ledit au moins un segment (28) de polysilicum de couche supérieure pour aboutir sur ladite zone dopée (12) pour former ledit trou de contact (26') s'étendant de la surface de la couche isolante la plus haute (30) jusqu'à ladite zone dopée;
(b) former dans ledit trou de contact un connecteur de matériau conducteur (32) qui le remplit substantiellement et y est contenu; ledit connecteur étant en contact bout à bout avec ledit segment (28) de polysilicium de couche supérieure, et avec une portion de ladite zone dopée (12).

**14.** Un procédé selon la Revendication 13, caractérisé en ce que ladite portion dudit circuit intégré comprend en outre un segment (22) de polysilicium de première couche relié à la grille d'un transistor MOS, dont une portion est séparée de ladite zone dopée par un oxyde de grille (23), et en ce que la gravure dudit trou de contact aboutit également sur une portion dudit segment (22) de polysilicium de première couche.

**15.** Un procédé selon la Revendication 14, caractérisé en ce que ladite zone dopée de matériau semi-conducteur (12) comporte du silicium et en ce que lesdites couches supérieures (30, 24) de matériau isolant comportent du dioxyde de silicium.

**16.** Un procédé selon la Revendication 15, caractérisé en ce que ladite configuration dudit trou de contact et la gravure à travers celui-ci s'effectuent selon un procédé de gravure en deux étapes qui comporte:

(a) une première étape de gravure non sé-lective comprenant une gravure anisotropi-que, non spécifique envers lesdits segments de polysilicium de couche supérieure et lesdites couches supérieures de dioxyde dc silicium, destinée à graver à travers lesdits segments de polysilicium de couche supérieure et lesdites couches supérieures de dioxyde de silicium; et
(b) une seconde étape de gravure sélective comprenant une gravure anisotropique sélective envers le silicium et le polysilicium, destinée à graver à travers toute portion restante de la plus basse desdites couches supérieures de dioxyde de silicium.

**17.** Un procédé selon la Revendication 16, caractérisé en ce que le passage de ladite première étape de gravure non sélective à ladite seconde étape de gravure sélective s'effectue à l'achèvement de la gravure à travers le plus bas desdits segments de polysilicium de couche supérieure et avant d'atteindre la zone de silicium dopée ou ledit segment de polysilicium de première couche.

**18.** Un procédé selon la Revendication 16, dans lequel ledit circuit semi-conducteur intégré est une cellule de mémoire RAM statique à quatre transistors.

**19.** Un procédé selon l'une quelconque des Revendications 13 à 18, caractérisé en ce que ledit connecteur est constitué de tungstène ou de polysilicium dopé qui remplit substantiellement et est contenu au sein dudit trou de contact (26'), ledit polysilicium dopé (28) ayant le même type de conductivité que ladite zone dopée (12).

**20.** Un procédé selon l'une quelconque des Revendications 16 à 19, caractérisé en ce que le passage de ladite première étape de gravure non sélective à ladite seconde étape de gravure sélective s'effectue à l'achèvement de la gravure à travers le plus bas desdits segments de polysilicium de couche supérieure et avant d'atteindre ladite zone dopée ou ledit segment de polysilicium de première couche.

**21.** Un procédé selon l'une quelconque des Revendications 16 à 20, caractérisé en ce que ladite première étape de gravure non sélective grave ledit dioxyde de silicium à une vitesse allant d'environ 0,75 à 1,5 fois celle dudit polysilicium.

22. Un procédé selon l'une quelconque des Revendications 16 à 21, caractérisé en ce que ladite seconde étape de gravure sélective grave ledit dioxyde de silicium à une vitesse d'au moins environ 10 fois celle dudit silicium et dudit polysilicium.

23. Un procédé selon l'une quelconque des Revendications 16 à 22, caractérisé en ce que ladite gravure comprend une corrosion ionique réactive utilisant une chimie CHF3 ET O2.

24. Un procédé selon l'une quelconque des Revendications 13 à 23, caractérisé en ce que ledit trou de contact (26') est formé en même temps que les trous de contact destinés à interconnecter le métal avec les zones dopées ou avec le polysilicium.

25. Un procédé selon l'une quelconque des Revendications 13 à 24, caractérisé par la formation d'une couverture isolante du connecteur entre ledit connecteur et une interconnexion métallique sus-jacente.

26. Un procédé selon la Revendication 25, caractérisé en ce que ladite couverture isolante du connecteur comporte du dioxyde de silicium ou du nitrure de silicium.

FIG. 1
( PRIOR ART )

FIG. 2
( PRIOR ART )

FIG. 3

FIG. 4A

FIG. 4B

FIG. 4C

FIG. 4D